# EUROPEAN PATENT APPLICATION

(11) **EP 4 801 206 A1**
(43) Date of publication of application: **02.09.2026**
(21) Application number: 25215364.8
(22) Date of filing: 12.11.2025
(51) Int. Cl.: H05K 5/02, H05K 7/14, H05K 7/20, H02M 7/00

(54) **POWER CONVERSION SYSTEM**

(30) Priority: 27.02.2025 CN 202510227991
(71) Applicant: Zhejiang Jinko Energy Storage Co., Ltd., Jiaxing, Zhejiang (CN)
(72) Inventor: CHENG, Min, Haining, Zhejiang (CN); XU, Guodong, Haining, Zhejiang (CN); SUN, Xuebing, Haining, Zhejiang (CN); ZHANG, Jiayang, Haining, Zhejiang (CN); YU, Jian, Haining, Zhejiang (CN); ZHANG, Luhua, Haining, Zhejiang (CN)
(74) Representative: Balder IP Law, S.L.

(57) **Abstract**

The present disclosure relates to the technical field of energy storage, and provides a power conversion system which has at least improved heat dissipation efficiency. The power conversion system includes a housing, partitions, a heat sink, and a fan assembly. A first partition divides a high-voltage compartment in the housing into upper and lower high-voltage compartments arranged vertically. A second partition and a third partition divide a low-voltage compartment in the housing into upper, middle, and lower low-voltage compartments sequentially arranged from top to bottom.

## Description

### TECHNICAL FIELD

The present disclosure relates to the technical field of energy storage, and in particular to a power conversion system.

### BACKGROUND

The high-voltage box and the power conversion system (PCS) are core devices of an energy storage system. The PCS serves as a key component that enables bidirectional flow of electrical energy between the energy storage system and the power grid, and is configured to control the charging and discharging processes of the battery and to perform conversion between alternating current power and direct current power.

### SUMMARY

Embodiments of the present disclosure provides a power conversion system including: a housing including a high-voltage compartment and a low-voltage compartment adjacent to each other in a horizontal side-by-side arrangement, the high-voltage compartment configured to accommodate high voltage components, the low-voltage compartment configured to accommodate low voltage component; a first partition arranged in the high-voltage compartment dividing the high-voltage compartment horizontally into an upper high-voltage compartment and a lower high-voltage compartment that are stacked vertically, where the lower high-voltage compartment has an air inlet on a side away from the low-voltage compartment; a second partition arranged horizontally in the low-voltage compartment and arranged on the same level as the first partition; a third partition arranged in the low-voltage compartment above the second partition, where the second partition and the third partition divide the low-voltage compartment horizontally into an upper low-voltage compartment, a middle low-voltage compartment, and a lower low-voltage compartment that are tacked sequentially from top to bottom, and the lower low-voltage compartment has an air outlet on a side away from the high-voltage compartment; a heat sink arranged between the lower low-voltage compartment and the lower high-voltage compartment, where a side of the first partition adjacent to the low-voltage compartment is fixed to a top of the heat sink, and a side of the second partition adjacent to the high-voltage compartment is fixed to the top of the heat sink; and a fan assembly arranged in the lower high-voltage compartment having its airflow directed toward the heat sink. Cooling air enters through the air inlet, passes through the fan assembly and the heat sink into the lower low-voltage compartment, and is discharged through the air outlet, thereby forming a first airflow channel. A side of the first partition adjacent to the heat sink is provided with a plurality of vents, and cooling air flows from the air inlet through the fan assembly and the vents into the middle low-voltage compartment, thereby forming a second airflow channel. A flow rate in the first airflow channel is greater than a flow rate in the second airflow channel.

In some embodiments, at least one exhaust vent is provided on a side of the middle low-voltage compartment and/or the upper low-voltage compartment away from the high-voltage compartment, and at least one exhaust fan is disposed at the at least one exhaust vent.

In some embodiments, an upper portion of at least one of the exhaust vents is located in the upper low-voltage compartment, and a lower portion of at least one of the exhaust vent is located in the middle low-voltage compartment.

In some embodiments, the at least one exhaust fan is configured to draw air from the upper low-voltage compartment to form a third airflow channel, and a flow rate in the third airflow channel is less than the flow rate in the second airflow channel.

In some embodiments, the fan assembly includes: an air inlet grille, detachably fixed to the air inlet; a fan bracket, detachably fixed to the air inlet grille; and fans, detachably fixed to the fan bracket.

In some embodiments, a bottom of the housing has a guide rail, and the fan bracket is movably fixed to the guide rail.

In some embodiments, the first partition includes a first portion, a second portion, and a third portion connected sequentially, where a height of the first portion relative to a bottom of the housing is greater than a height of the third portion relative to the bottom of the housing, a side of the third portion away from the second portion is fixed to the top of the heat sink, and the vents are provided on the second portion.

In some embodiments, at least one of the first partition, the second partition, or the third partition includes a plurality of bent sections, each bent section being provided with a plurality of fastening holes, and the first partition, the second partition, or the third partition being fixed to an inner wall of the housing by bolts passing the plurality of fastening holes.

In some embodiments, a cushioning pad is provided between the inner wall of the housing and the bent sections, and the cushioning pad is made of a rubber material.

In some embodiments, the power conversion system further includes two fixing portions arranged opposite along a direction perpendicular to arrangement of the high-voltage compartment and the low-voltage compartment, where the fixing portions are located between the lower low-voltage compartment and the lower high-voltage compartment and fixed to an inner wall of the housing, and two ends of the heat sink are fixed to the fixing portions to suspend the heat sink within the housing.

### BRIEF DESCRIPTION OF THE DRAWINGS

One or more embodiments are illustrated by way of Figures in the drawings. These illustrations do not constitute a limitation on the embodiments, unless explicitly stated otherwise, and the drawings are not drawn to scale. For the purpose of more clearly describing the technical solution of the embodiments of the present disclosure or conventional techniques, a brief introduction of the drawings used in the embodiments is provided below. It is apparent that the drawings described below are merely some embodiments of the present disclosure, and those skilled in the art can obtain other drawings based on these drawings without exercising inventive skill.
FIG. 1 is a schematic diagram showing a power conversion system in one perspective view according to embodiments of the present disclosure.
FIG. 2 is a schematic diagram showing the power conversion system in another perspective view according to embodiments of the present disclosure.
FIG. 3 is a schematic diagram showing an internal structure of the power conversion system according to embodiments of the present disclosure.
FIG. 4 is a schematic diagram showing a first partition according to embodiments of the present disclosure.
FIG. 5 is a schematic diagram showing a fan assembly according to embodiments of the present disclosure.
FIG. 6 is a schematic diagram showing a second partition according to embodiments of the present disclosure.
FIG. 7 is a schematic diagram showing a third partition according to embodiments of the present disclosure.

### Reference numerals:

| | | | |
|---|---|---|---|
| 100, | housing; | 101, | high-voltage compartment; |
| 102, | low-voltage compartment; | 103, | upper high-voltage compartment; |
| 104, | lower high-voltage compartment; | 105, | upper low-voltage compartment; |
| 106, | middle low-voltage compartment; | 107, | lower low-voltage compartment; |
| 108, | air inlet; | 109, | air outlet; |
| 110, | first partition; | 111, | first portion; |
| 112, | second portion; | 113, | third portion; |
| 114, | vent; | 120, | second partition; |
| 121, | fourth portion; | 122, | fifth portion; |
| 123, | sixth portion; | 124, | hollowed-out section; |
| 130, | third partition; | 131, | seventh portion; |
| 132, | eighth portion; | 133, | ninth portion; |
| 134, | isolation section; | 140, | heat sink; |
| 150, | fan assembly; | 151, | air inlet grille; |
| 152, | fan bracket; | 153, | fan; |
| 160, | exhaust vent; | 161, | exhaust fan; |
| 170, | recess; | 180, | inductor; |
| 190, | bent section; | 193, | fixing section. |

### DETAILED DESCRIPTION OF THE EMBODIMENTS

As known from the BACKGROUND, the heat dissipation efficiency of power conversion systems needs to be improved.

A power conversion system is provided according to embodiments of the present disclosure, at least advantageous in improving heat dissipation efficiency.

In the description of the embodiments of the present disclosure, the technical terms "first," "second," and the like are merely used to distinguish between different technical features, and should not be construed as indicating or implying relative importance, or as defining the number, sequence, or hierarchy of the indicated technical features.

In the description of the embodiments of the present disclosure, the term "a plurality of" means two or more, unless otherwise explicitly defined.

The term "embodiment" herein means that a particular feature, structure, or characteristic described in connection with the embodiment may be included in at least one embodiment of the present disclosure. The appearances of the same term throughout the specification do not necessarily all refer to the same embodiment, and the embodiments are not mutually exclusive of one another. It will be understood by those skilled in the art, explicitly and implicitly, that the embodiments described herein can be combined with one another.

In the description of the embodiments of the present disclosure, the term "and/or" is merely an expression of an associative relationship between the associated objects, indicating that three relationships may exist. For example, "A and/or B" may refer to: the presence of A alone, the presence of both A and B, or the presence of B alone. In addition, the character "/" as used herein generally indicates that the objects connected thereby are in an "or" relationship.

In the description of the embodiments of the present disclosure, technical terms such as "center," "longitudinal," "lateral," "length," "width," "thickness," "upper," "lower," "front," "rear," "left," "right," "vertical," "horizontal," "top," "bottom," "inner," "outer," "clockwise," "counterclockwise," "axial," "radial," and "circumferential" indicate positional or directional relationships based on the orientations or positions shown in the drawings. These terms are used merely for convenience of description and simplification of the embodiments, and are not intended to indicate or imply that the devices or elements referred to must be constructed or operated in any particular orientation. Therefore, such expressions should not be construed as limiting the embodiments of the present disclosure.

In the description of the embodiments of the present disclosure, unless otherwise expressly specified or limited, the technical terms "mounted," "connected," "coupled," "fixed," and the like should be understood in a broad sense, for example, a fixed connection, a detachable connection, an integral formation, a mechanical connection, an electrical connection, a direct or indirect connection, communication between two devices or an interaction relationship between two devices. Those skilled in the art can understand the specific meanings of the above terms in the embodiments of the present disclosure according to the context.

In the description of the embodiments of the present disclosure, unless otherwise expressly specified or limited, the term "low voltage " refers to electrical voltages of 1000 volts or less, including but not limited to 220 V, 240 V, and 380 V. The term "high voltage" refers to electrical voltages of above 1000 volts, including but not limited to 6 kV, 10 kV, 35 kV, 110 kV, and 220 kV.

In the description of the embodiments of the present disclosure, when a component is described as "including" another component, unless otherwise specified, it does not exclude the presence of other devices, and other devices may also be included.

The terminology used in the description of the various embodiments herein is for the purpose of describing particular embodiments only and is not intended to be limiting. As used in the description of the embodiments and the claims, the term "component" is also intended to include the plural form unless the context clearly indicates otherwise.

The embodiments of the present disclosure will be described in detail below with reference to the drawings. However, those skilled in the art will understand that numerous technical details are provided in the embodiments merely to facilitate a better understanding of the present disclosure. The technical solutions claimed in the present disclosure can be implemented even without such details or through various modifications and variations based on the following embodiments.

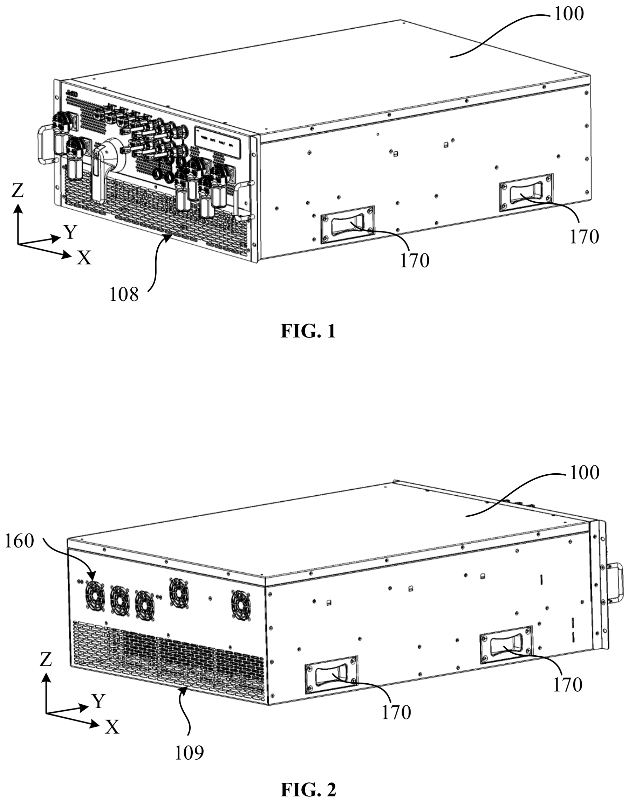

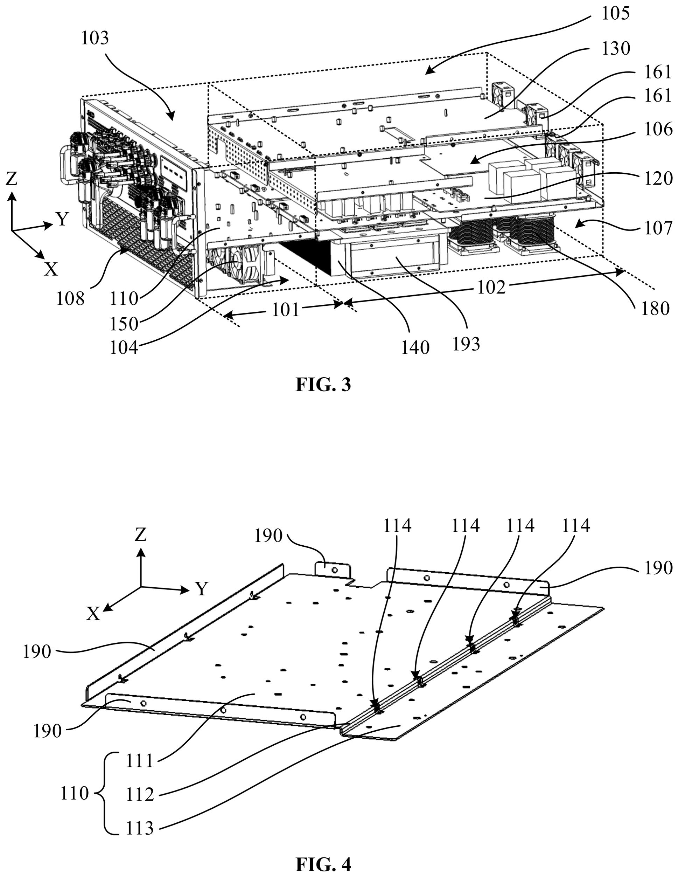

FIG. 1 is a schematic diagram showing a power conversion system in one perspective view according to embodiments of the present disclosure. FIG. 2 is a schematic diagram showing the power conversion system in another perspective view according to embodiments of the present disclosure. FIG. 3 is a schematic diagram showing an internal structure of the power conversion system according to embodiments of the present disclosure. FIG. 4 is a schematic diagram showing a first partition according to embodiments of the present disclosure. In FIG. 3, for ease of illustration, the housing 100 is shown in a transparent view, and the outline of the housing 100 as well as the boundary between the high-voltage compartment 101 and the low-voltage compartment 102 are indicated by dashed lines.

In the drawings provided in these embodiments, the X-axis direction corresponds to the width of the housing 100 of the power conversion system, the Y-axis direction corresponds to the length of the housing 100, and the Z-axis direction corresponds to the height of the housing 100.

Referring to FIGS. 1 to 4, the power conversion system according to embodiments of the present disclosure a housing 100, and a first partition 110, a second partition 120, a third partition 130, a heat sink 140, and a fan assembly 150 arranged within the housing 100.

The housing 100 includes a high-voltage compartment 101 and a low-voltage high-voltage compartment 102 that are adjacent to each other in a horizontal side-by-side arrangement, the high-voltage compartment configured to accommodate high voltage components, the low-voltage compartment configured to accommodate low voltage components. The first partition 110 is arranged in the high-voltage compartment 101 and divides the high-voltage compartment 101 horizontally into an upper high-voltage compartment 103 and a lower high-voltage compartment 104 that are stacked vertically. An air inlet 108 is provided on a side of the lower high-voltage compartment 104 away from the low-voltage compartment 102. The second partition 120 is arranged horizontally in the low-voltage compartment 102 and on a same level as the first partition 110. The third partition 130 is also arranged in horizontally the low-voltage compartment 102 and is located above the second partition 120. The second partition 120 and the third partition 130 divide the low-voltage compartment 102 horizontally into an upper low-voltage compartment 105, a middle low-voltage compartment 106, and a lower low-voltage compartment 107 sequentially from top to bottom. An air outlet 109 is provided on a side of the lower low-voltage compartment 107 away from the high-voltage compartment 101. The heat sink 140 is arranged between the lower low-voltage compartment 107 and the lower high-voltage compartment 104. A side of the first partition 110 adjacent to the low-voltage compartment 102 is fixed to the top of the heat sink 140, and a side of the second partition 120 adjacent to the high-voltage compartment 101 is fixed to the top of the heat sink 140. The fan assembly 150 is arranged in the lower high-voltage compartment 104, with its airflow directed toward the heat sink 140.

Cooling air enters through the air inlet 108, passes through the fan assembly 150 and the heat sink 140, then flows into the lower low-voltage compartment 107 and finally is discharged from the air outlet 109, thereby forming a first airflow channel. Referring to FIGS. 3 and 4, a side of the first partition 110 adjacent to the heat sink 140 is provided with a plurality of vents 114. The cooling air flows from the air inlet 108 through the fan assembly 150 and the vents 114 into the middle low-voltage compartment 106, thereby forming a second airflow channel. A flow rate of the first airflow channel is greater than that of the second airflow channel.

For the power conversion system provided in the embodiments of the present disclosure, the housing 100 includes adjacent high-voltage and low-voltage compartments 101 and 102. The high-voltage compartment 101 is configured to accommodate high-power devices, and the low-voltage compartment 102 is configured to accommodate low-power devices, thereby improving the integration density of the power conversion system. The first partition 110 divides the high-voltage compartment 101 into an upper high-voltage compartment 103 and a lower high-voltage compartment 104 arranged vertically. The second partition 120 and the third partition 130 divide the low-voltage compartment 102 into an upper low-voltage compartment 105, a middle low-voltage compartment 106, and a lower low-voltage compartment 107 sequentially from top to bottom. In this manner, the spaces of the high-voltage compartment 101 and the low-voltage compartment 102 are further divided into multiple regions. A side of the lower high-voltage compartment 104 away from the low-voltage compartment 102 is provided with an air inlet 108, and a side of the lower low-voltage compartment 107 away from the high-voltage compartment 101 is provided with an air outlet 109. A heat sink 140 is arranged between the lower low-voltage compartment 107 and the lower high-voltage compartment 104. Cooling air enters through the air inlet 108, passes through the fan assembly 150 and the heat sink 140, flows into the lower low-voltage compartment 107, and is discharged through the air outlet 109, thereby forming a unidirectional first airflow channel. In this way, the heated air that cools the heat sink 140 is directly discharged through the air outlet 109 without circulating inside the housing 100, thereby preventing the high-temperature air from affecting the cooling performance of other devices. A side of the first partition 110 adjacent to the heat sink 140 is provided with a plurality of vents 114. Cooling air flows from the air inlet 108 through the fan assembly 150 and the vents 114 into the middle low-voltage compartment 106, thereby forming a unidirectional second airflow channel. In this way, devices arranged in the middle low-voltage compartment 106 can not only dissipate heat through the heat sink 140 but also through the second airflow channel formed in the middle low-voltage compartment 106, thereby improving the cooling efficiency of the devices therein. A flow rate of the first airflow channel is greater than a flow rate of the second airflow channel. As such, most of the heat generated by the devices on the heat sink 140 is dissipated through the first airflow channel. Even though a small portion of the heat is transferred through the second airflow channel to the devices located farther away from the high-voltage compartment 101, it has little effect on the cooling of the devices at the downstream end of the second airflow channel, thereby allowing the devices in the middle low-voltage compartment 106 that are farther away from the high-voltage compartment 101 to also achieve effective cooling performance.

In some embodiments, switch baffles may be provided at the vents. The switch baffles may control the opening or closing of the vents. This allows the number of vents to be tuned according to the ambient temperature of the power conversion system, thereby regulating the flow rate in the second air flow channel. For example, the heat dissipation demand is reduced at a relatively low ambient temperature, some of the switch baffles can be closed to lower the flow rate in the second air flow channel, thereby preventing the temperature of devices from becoming excessively low after heat dissipation, which could otherwise lead to improper operation.

Referring to FIGS. 2 and 3, at least one exhaust vent 160 may be provided on the side of the middle low-voltage compartment 106 and/or the upper low-voltage compartment 105 of the housing 100 that faces away from the high-voltage compartment 101, and at least one exhaust fan 161 is arranged at the exhaust vent 160. The at least one exhaust fan 161 at the exhaust vent 160 facilitates the discharge of cooling air that has passed through the second air flow channel, thereby preventing heat from accumulating within the housing 100 and improving the heat dissipation efficiency of the power conversion system.

In some embodiments, referring to FIG. 3, the upper portion of at least one exhaust vent 160 may be located in the upper low-voltage compartment 105, and the lower portion of the same exhaust vent 160 may be located in the middle low-voltage compartment 106. In this way, the upper low-voltage compartment 105 and the middle low-voltage compartment 106 may share a single exhaust fan 161 to achieve unidirectional airflow, thereby reducing the installation cost of the exhaust fan 161 while improving the heat dissipation efficiency of the devices in the upper and middle low-voltage compartments 105 and 106.

In some embodiments, the at least one exhaust fan 161 draws air from the upper low-voltage compartment 105 to form a third airflow channel, where the flow rate in the third airflow channel is lower than the flow rate in the second airflow channel. In this manner, devices generating relatively high heat, such as power boards or DC-link capacitors, may be arranged in the middle low-voltage compartment 106, while devices generating relatively low heat, such as a battery management system, a control board, or an auxiliary capacitor board, may be arranged in the upper low-voltage compartment 105. Arranging devices with different heat generation rates in separate compartments can facilitate efficient heat dissipation.

Furthermore, as the upper low-voltage compartment 105 and the middle low-voltage compartment 106 share a single exhaust fan 161, the portion of the exhaust vent 160 located in the middle low-voltage compartment 106 is larger than the portion located in the upper low-voltage compartment 105, such that the flow rate in the third airflow channel is lower than that in the second airflow channel.

Referring to FIG. 1, recesses 170 may be provided on both sides of the housing 100 along the width direction, thereby facilitating transportation of the power conversion system.

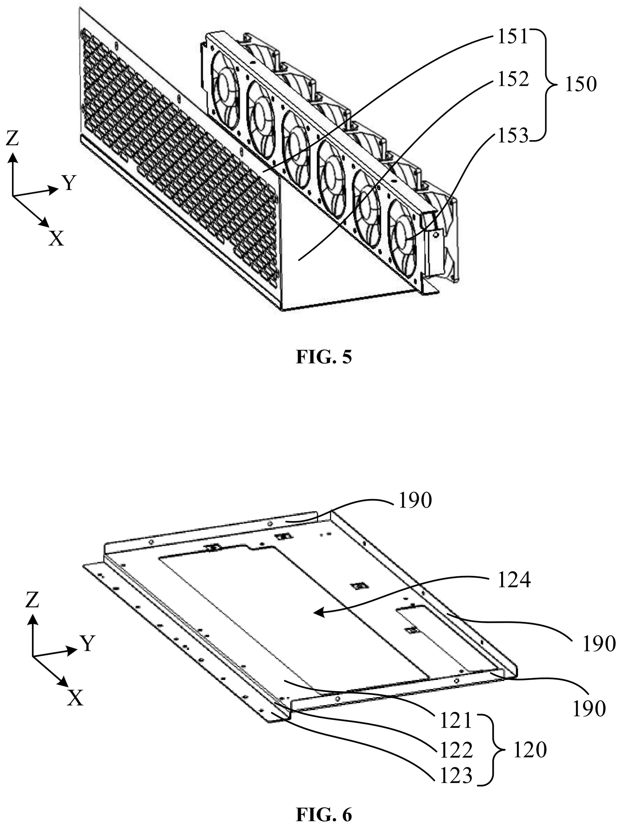

FIG. 5 is a schematic diagram showing the fan assembly according to embodiments of the present disclosure.

Referring to FIGS. 3 and 5, the fan assembly 150 includes an air inlet grille 151, a fan bracket 152, and fans 153. The air inlet grille 151 is detachably fixed to the air inlet 108. The fan bracket 152 is detachably fixed to the air inlet grille 151. The fans 153 are detachably fixed to the fan bracket 152. In this manner, the fans 153 may be detachably mounted to the housing 100 via the fan bracket 152 and the air inlet grille 151. When servicing of the fans 153 is required, the fans 153 can be directly removed by detaching the air inlet grille 151 at the air inlet 108, without the disassemble the third partition 130, the second partition 120, or the first partition 110 sequentially. This design facilitates convenient servicing of the fans 153.

In this embodiment, as an example, a plurality of fans 153 are fixed by means of a common fan bracket 152 and a common air inlet grille 151. In other embodiments, the air inlet grille and the fan bracket may be provided as multiple sets, thereby forming a plurality of mutually independent fan assemblies. Each of the fan assemblies is fixed to the housing 100 via its respective air inlet grille. In this way, when a single fan requires servicing, it is unnecessary to disassemble the other fan assemblies.

In some embodiments, the bottom of the housing may be provided with a guide rail (not shown), and the fan bracket may be movably fixed to the guide rail. In this manner, when the fan assembly is installed or removed through the air inlet of the housing, it may be guided along the rail, which facilitates more efficient installation of the fan assembly and improves the stability of the fan assembly after mounted within the housing.

Referring to FIG. 4, the first partition 110 may include a first portion 111, a second portion 112, and a third portion 113 connected sequentially. A height of the first portion 111 relative to the bottom of the housing is greater than a height of the third portion 113 relative to the bottom of the housing. A side of the third portion 113 away from the second portion 112 is fixed to the top of the heat sink, and vents 114 are provided on the second portion 112. In this manner, the first portion 111 and the third portion 113 are staggered, allowing the cooling air to concentrate at the second portion 112. Arranging the vents 114 on the second portion 112 facilitates efficient flow of cooling air through the vents 114 toward the middle low-voltage compartment.

FIG. 6 is a schematic diagram showing the second partition according to embodiments of the present disclosure.

Referring to FIG. 6, the second partition 120 may also include a fourth portion 121, a fifth portion 122, and a sixth portion 123 connected sequentially. A height of the fourth portion 121 relative to the bottom of the housing is greater than a height of the fifth portion 122 relative to the bottom of the housing. A side of the sixth portion 123 away from the fifth portion 122 is fixed to the top of the heat sink.

Referring to FIGS. 3 and 6, the lower low-voltage compartment 107 may accommodate a plurality of inductors 180, and the second partition 120 may include a hollowed-out section 124. The orthogonal projection of each inductor 180 on the bottom of the housing 100 is located within the orthogonal projection of the hollowed-out section 124 on the bottom of the housing 100. Because the inductors 180 are relatively large in volume, disposing them in the lower low-voltage compartment 107 improves space utilization. Providing the hollowed-out section 124 in the second partition 120 avoids electromagnetic interference between the second partition 120 and the inductors 180.

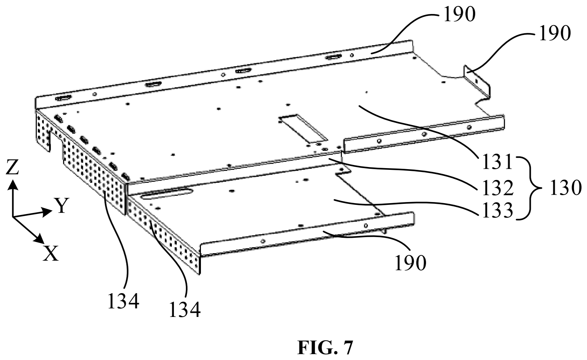

FIG. 7 is a schematic diagram showing the third partition according to embodiments of the present disclosure.

Referring to FIG. 7, the third partition 130 may include a seventh portion 131, an eighth portion 132, and a ninth portion 133 connected sequentially. A height of the seventh portion 131 relative to the bottom of the housing is greater than a height of the ninth portion 133 relative to the bottom of the housing. In this way, staggering the seventh portion 131 and the ninth portion 133 facilitates placement of devices of different heights, thereby improving space utilization in the upper low-voltage compartment.

Referring to FIGS. 3 and 7, a side of the seventh portion 131 and a side of the ninth portion 133 adjacent to the high-voltage compartment 101 are bent toward the bottom of the housing 100 to form an isolation section 134 provided with an array of openings. The isolation section 134 can separate devices between the high-voltage compartment 101 and the low-voltage compartment 102. The openings on the isolation section 134 can provide electromagnetic shielding to prevent electromagnetic interference between devices in the high-voltage compartment 101 and devices in the low-voltage compartment 102.

In some embodiments, the orthogonal projection of the seventh portion 131 on the bottom of the housing overlaps with the orthogonal projection of the second partition 120, while the orthogonal projection of the ninth portion 133 on the bottom of the housing does not overlap with the orthogonal projection of the second partition 120. In this manner, the height of some devices on the second partition 120 can exceed the distance between the second partition 120 and the third partition 130, allowing relatively large devices to be arranged on the second partition 120.

In some embodiments, at least one of the first partition 110, the second partition 120, or the third partition 130 includes a plurality of bent sections 190, each being provided with a plurality of fastening holes. The first partition 110, the second partition 120, or the third partition 130 is fixed to the inner wall of the housing 100 by bolts passing through the fastening holes.

In other embodiments, the inner wall of the housing is provided with a plurality of support portions, which include a first support portion and a second support portion connected to each other. The first support portion is parallel to the side surface of the housing and is used for fixation to the side wall of the housing. The second support portion is parallel to the bottom surface of the housing and is used for fixation to the first partition, the second partition, or the third partition.

In some embodiments, a cushioning pad (not shown) is arranged between the inner wall of the housing and the bent sections. The cushioning pad may be made of rubber. The cushioning pad can prevent deformation of the housing, the first partition, the second partition, or the third partition caused by mutual pressing due to thermal expansion or contraction.

Referring to FIGS. 1 to 3, the power conversion system may further include two fixing portions 193 arranged opposite each other along a direction perpendicular to the arrangement of the high-voltage compartment 101 and the low-voltage compartment 102. The fixing portions 193 are arranged between the lower low-voltage compartment 107 and the lower high-voltage compartment 104 and are fixed to the inner wall of the housing 100. Both ends of the heat sink 140 are fixed to the fixing portions 193, such that the heat sink 140 is suspended within the housing 100. Suspending the heat sink 140 within the housing 100 via the fixing portions 193 allows cooling air to flow underneath the heat sink 140, thereby improving the heat dissipation performance of the heat sink 140.

For the power conversion system provided in the embodiments of the present disclosure, the housing 100 includes adjacent high-voltage and low-voltage compartments 101 and 102. The high-voltage compartment 101 is configured to accommodate high-power devices, and the low-voltage compartment 102 is configured to accommodate low-power devices, thereby improving the integration density of the power conversion system. The first partition 110 divides the high-voltage compartment 101 into an upper high-voltage compartment 103 and a lower high-voltage compartment 104 arranged vertically. The second partition 120 and the third partition 130 divide the low-voltage compartment 102 into an upper low-voltage compartment 105, a middle low-voltage compartment 106, and a lower low-voltage compartment 107 sequentially from top to bottom. In this manner, the spaces of the high-voltage compartment 101 and the low-voltage compartment 102 are further divided into multiple regions. A side of the lower high-voltage compartment 104 away from the low-voltage compartment 102 is provided with an air inlet 108, and a side of the lower low-voltage compartment 107 away from the high-voltage compartment 101 is provided with an air outlet 109. A heat sink 140 is arranged between the lower low-voltage compartment 107 and the lower high-voltage compartment 104. Cooling air enters through the air inlet 108, passes through the fan assembly 150 and the heat sink 140, flows into the lower low-voltage compartment 107, and is discharged through the air outlet 109, thereby forming a unidirectional first airflow channel. In this way, the heated air that cools the heat sink 140 is directly discharged through the air outlet 109 without circulating inside the housing 100, thereby preventing the high-temperature air from affecting the cooling performance of other devices. A side of the first partition 110 adjacent to the heat sink 140 is provided with a plurality of vents 114. Cooling air flows from the air inlet 108 through the fan assembly 150 and the vents 114 into the middle low-voltage compartment 106, thereby forming a unidirectional second airflow channel. In this way, devices arranged in the middle low-voltage compartment 106 may not only dissipate heat through the heat sink 140 but also through the second airflow channel formed in the middle low-voltage compartment 106, thereby improving the cooling efficiency of the devices therein. A flow rate of the first airflow channel is greater than that of the second airflow channel. As such, most of the heat generated by the devices on the heat sink 140 is dissipated through the first airflow channel. Even though a small portion of the heat is transferred through the second airflow channel to the devices located farther away from the high-voltage compartment 101, it has little effect on the cooling of the devices at the downstream end of the second airflow channel, thereby allowing the devices in the middle low-voltage compartment 106 that are farther away from the high-voltage compartment 101 to also achieve effective cooling performance.

Those skilled in the art will understand that the above-described embodiments are specific implementations of the present disclosure, and that in actual applications, various modifications may be made in form and detail without departing from the scope of the present disclosure. Any person skilled in the art may make various alterations and modifications within the scope of the present disclosure. Therefore, the protection scope of the present disclosure should be defined by the claims.

## Claims

1. A power conversion system, comprising:
a housing (100) including a high-voltage compartment (101) and a low-voltage compartment (102) adjacent to each other in a horizontal side-by-side arrangement, the high-voltage compartment configured to accommodate high voltage components, the low-voltage compartment configured to accommodate low voltage components;
a first partition (110) arranged in the high-voltage compartment (101), wherein the first partition (110) divides the high-voltage compartment (101) horizontally into an upper high-voltage compartment (103) and a lower high-voltage compartment (104) that are stacked vertically, and the lower high-voltage compartment (104) has an air inlet (108) on a side away from the low-voltage compartment (102);
a second partition (120) arranged horizontally in the low-voltage compartment (102) and arranged on the same level as the first partition (110).

2. The power conversion system according to claim 1, further comprising:
a third partition (130) arranged horizontally in the low-voltage compartment (102) above the second partition (120), wherein the second partition (120) and the third partition (130) divide the low-voltage compartment (102) horizontally into an upper low-voltage compartment (105), a middle low-voltage compartment (106), and a lower low-voltage compartment (107) that are tacked sequentially from top to bottom, and the lower low-voltage compartment (107) has an air outlet (109) on a side away from the high-voltage compartment (101).

3. The power conversion system according to claim 2, further comprising:
a heat sink (140) arranged between the lower low-voltage compartment (107) and the lower high-voltage compartment (104), wherein a side of the first partition (110) adjacent to the low-voltage compartment (102) is fixed to a top of the heat sink (140), and a side of the second partition (120) adjacent to the high-voltage compartment (101) is fixed to the top of the heat sink (140); and
a fan assembly (150) arranged in the lower high-voltage compartment (104), with the airflow of the fan assembly (150) directed toward the heat sink (140),
wherein cooling air enters through the air inlet (108), passes through the fan assembly (150) and the heat sink (140) into the lower low-voltage compartment (107), and is discharged through the air outlet (109), thereby forming a first airflow channel; a side of the first partition (110) adjacent to the heat sink (140) is provided with a plurality of vents (114), and cooling air flows from the air inlet (108) through the fan assembly (150) and the plurality of vents (114) into the middle low-voltage compartment (106), thereby forming a second airflow channel; and a flow rate in the first airflow channel is greater than a flow rate in the second airflow channel.

4. The power conversion system according to claim 2 or 3, further comprising at least one exhaust vent (160) provided on a side of at least one of the middle low-voltage compartment (106) and the upper low-voltage compartment (105) away from the high-voltage compartment (101), and at least one exhaust fan (161) disposed at the at least one exhaust vent (160).

5. The power conversion system according to claim 4, wherein at least one of the at least one exhaust vent (160) has an upper portion located in the upper low-voltage compartment (105), and a lower portion located in the middle low-voltage compartment (106).

6. The power conversion system according to claim 5, wherein the at least one exhaust fan (161) is configured to draw air from the upper low-voltage compartment (105) to form a third airflow channel, and a flow rate in the third airflow channel is less than the flow rate in the second airflow channel.

7. The power conversion system according to claim 3, wherein the fan assembly (150) includes:
an air inlet grille (151) detachably fixed to the air inlet (108);
a fan bracket (152) detachably fixed to the air inlet grille (151); and
fans (153) detachably fixed to the fan bracket (152).

8. The power conversion system according to any of claims 3 to 7, wherein the first partition (110) includes a first portion (111), a second portion (112), and a third portion (113) connected sequentially, wherein a height of the first portion (111) relative to a bottom of the housing (100) is greater than a height of the third portion (113) relative to the bottom of the housing (100), a side of the third portion (113) away from the second portion (112) is fixed to the top of the heat sink (140), and the vents (114) are fixed on the second portion (112).

9. The power conversion system according to claim 3, wherein at least one of the first partition (110), the second partition (120), or the third partition (130) includes a plurality of bent sections (190), with a respective bent section (190) of the plurality of bent sections (190) being provided with a plurality of fastening holes, wherein the first partition (110), the second partition (120), or the third partition (130) is fixed to an inner wall of the housing (100) by bolts passing through the plurality of fastening holes.

10. The power conversion system according to claim 3, further comprising:
two fixing portions (193) arranged opposite to each other along a direction perpendicular to an arrangement direction of the high-voltage compartment (101) and the low-voltage compartment (102), wherein the two fixing portions (193) are located between the lower low-voltage compartment (107) and the lower high-voltage compartment (104) and fixed to an inner wall of the housing (100), and two ends of the heat sink (140) are fixed to the two fixing portions (193) to suspend the heat sink (140) in the housing (100).

11. The power conversion system according to claim 2 or 3, wherein a plurality of inductors (180) are accommodated in the lower low-voltage compartment (107).

12. The power conversion system according to any of claims 1-11, wherein recesses (170) are provided on both sides of the housing (100) along a width direction of the housing (100).

13. The power conversion system according to any of claims 7-10, wherein the fan assembly (150) is fixed to the housing (100) via the air inlet grille (151).

14. The power conversion system according to claim 3, wherein the second partition (120) includes a fourth portion (121), a fifth portion (122), and a sixth portion (123) connected sequentially.

15. The power conversion system according to claim 14, wherein a height of the fourth portion (121) relative to the bottom of the housing (100) is greater than a height of the fifth portion (122) relative to the bottom of the housing (100), and a side of the sixth portion (123) away from the fifth portion (122) is fixed to the top of the heat sink (140).
